# EUROPEAN PATENT SPECIFICATION

(11) **EP 0 884 838 B1**
(45) Date of publication and mention of the grant of the patent: **30.07.2003**
(21) Application number: 98303501.5
(22) Date of filing: 05.05.1998
(51) Int. Cl.: H03F 1/32

(54) **Amplifier**
Verstärker
Amplificateur

(30) Priority: 09.06.1997 JP 15058797
(43) Date of publication of application: 16.12.1998
(73) Proprietor: ALPS ELECTRIC CO., LTD., Ota-ku Tokyo 145 (JP)
(72) Inventor: Takayama, Akira, Soma-shi, Fukushima-ken (JP); Ogasawara, Yutaka, soma-shi, Fukushima-ken (JP)
(74) Representative: Kensett, John Hinton

(56) References cited:
- US-A- 4 511 857
- US-A- 5 221 908
- KHAN A A: "NOVEL BIFET COMPOSITE UNIT AND ITS APPLICATIONS" INTERNATIONAL JOURNAL OF ELECTRONICS, vol. 70, no. 2, 1 February 1991, pages 421-431, XP000208866

## Description

The present invention relates to a low distortion amplifier suitable for a wideband amplifier for simultaneously amplifying multiple signals different in frequency.

Heretofore, when an amplifying element was selected in the design of an amplifier, the characteristic of the distortion and the used purpose of the amplifying element were considered. That is, if secondary distortion was called in question, a bipolar transistor the secondary distortion of which was small was more often used than a field-effect transistor (FET) and if tertiary distortion was called in question, FET the tertiary distortion of which was small was more often used than a bipolar transistor.

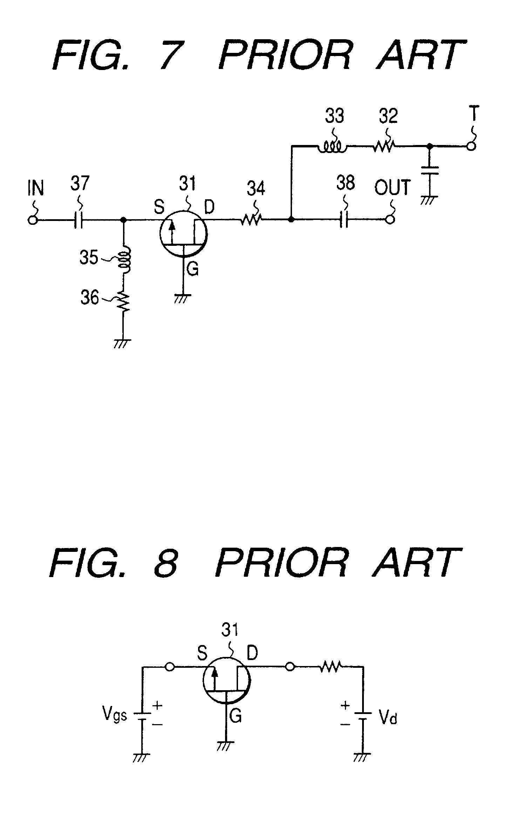

Referring to Figs. 7 to 11, a conventional type amplifier using FET as an amplifying element will be described below. First, Fig. 7 shows the circuit of this type of amplifier, single-gate N-channel FET is used for FET 31 which is an amplifying element and the gate G is grounded. Power supply voltage is supplied from a power terminal to the drain D which is an output terminal via a resistor 32 of approximately 10 Ω, a choke inductor 33 of approximately 0.1 µH and a resistor 34 of approximately 33 Ω respectively connected in series and the source S which is an input terminal is grounded via a choke inductor 35 of approximately 6.8 nH and a resistor 36 of approximately 82 Ω respectively connected in series. An input signal is input to the source S from the input terminal IN of an amplifier via direct current blocking capacitor 37 of 6.8 nF and an output signal from the drain D is extracted from the output terminal OUT of the amplifier via the resistor 34 and a direct current blocking capacitor 38.

The resistor 34 connected to the drain D is provided to prevent oscillation and the resistor 36 connected between the source S and the ground is provided to set bias voltage for biasing so that the voltage of the gate G for the source S is negative (approximately-0.7 V). Further, the choke inductors 33 and 35 are provided to block high frequency.

FET 31 is used for an amplifying element in the amplifier shown in Fig. 7 to solve tertiary distortion, however, as described above, FET 31 has a merit that tertiary distortion is small, compared with a bipolar transistor, while FET has a defect that secondary distortion is large, compared with a bipolar transistor. The reason is that relationship between input voltage and output current, that is, relationship between voltage between the source S and the gate G of FET 31 and drain current is provided with a characteristic close to a so-called quadratic function. As a result of measuring the voltage/current characteristic of FET 31 using a circuit shown in Fig. 8 to verify the above, relationship shown in Fig. 9 between gate bias voltage Vgs and drain current Id is obtained.

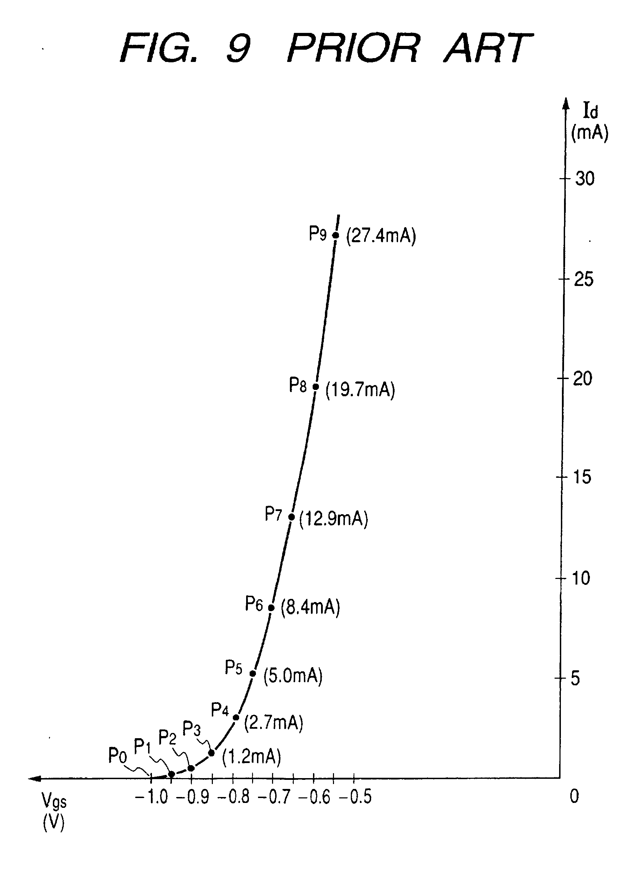

First, as for a measuring circuit shown in Fig. 8, the gate G of FET 31 is grounded and drain voltage Vd is applied to the drain D. Gate bias voltage Vgs for applying a voltage negative to the source S to the gate G is applied to the source S.. Fig. 9 shows a voltage/current characteristic showing a result of measuring the change of drain current Id if gate bias voltage Vgs is changed.

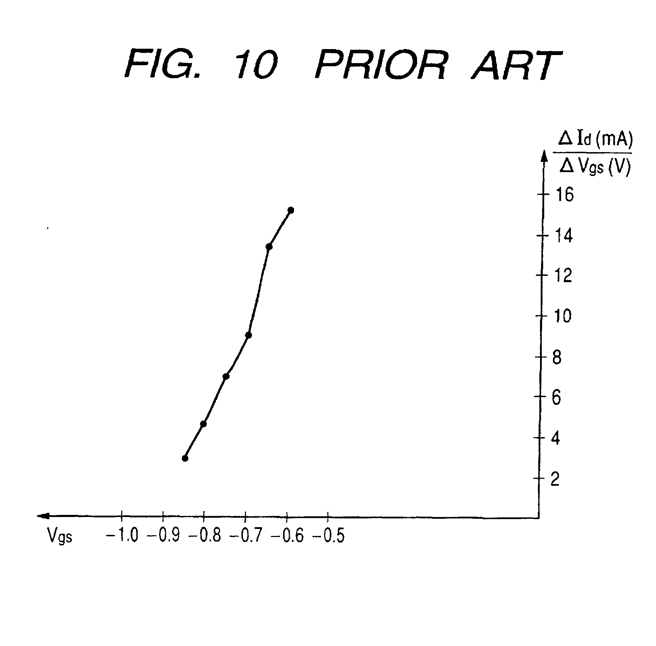

The x-axis of Fig. 9 shows gate bias voltage Vgs (the voltage of the gate G to the source S) and the y-axis shows drain current Id which flows to the drain D. As shown in the voltage/current characteristic, when gate voltage is changed from a minus toward 0 V, drain current increases and the tilt of the curve is sharper. That is, each point P0 to P9 on the curve shows drain current Id measured at gate bias voltage Vgs every 0.05 V and shows that as gate bias voltage Vgs is increased, a tilt between adjacent measurement points (ΔId/ΔVgs, ΔId shows difference of drain current between adjacent measurement points and ΔVgs is 0.05 V) is increased as shown in Fig. 10. The above tilt approximates a so-called differential coefficient and a tilt when the measurement interval (0.05 V) of the gate bias voltage Vgs in the above measurement is reduced infinitely is an accurate differential coefficient. However, in this specification, a tilt at an interval of 0.05 V described above is regarded as a differential coefficient for convenience.

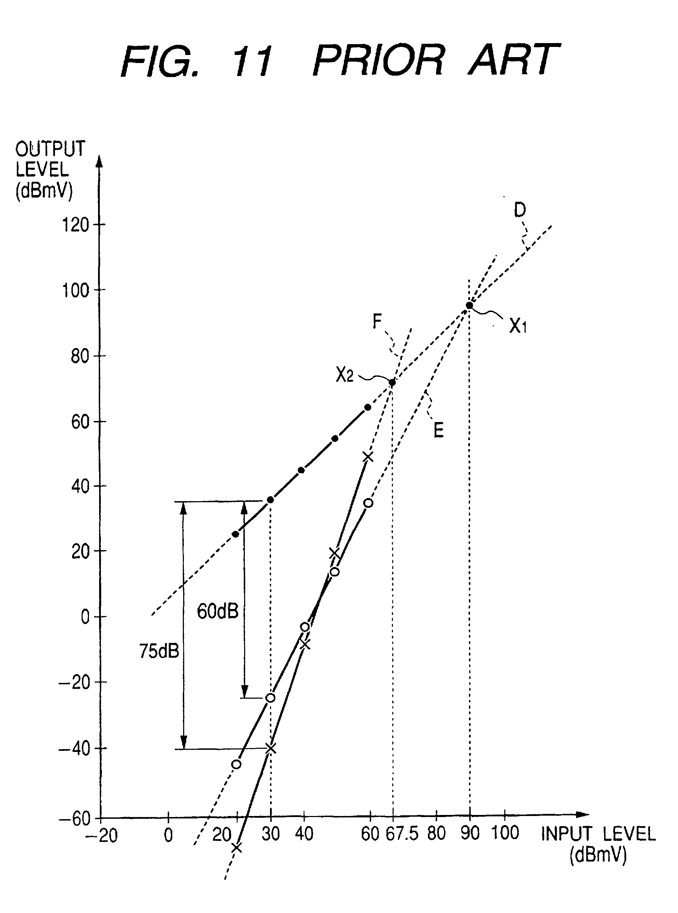

In the amplifier constituted as shown in Fig. 7 using FET 31 provided with such a voltage/current characteristic, when a signal is input to the input terminal IN of the amplifier, a fundamental signal with the same frequency as the input signal and a harmonic signal with an integer times as many as frequency of the frequency of the input signal are output to the output terminal OUT of the amplifier, and as the level of an input signal rises, the respective frequencies are increased. The above harmonic signal is generated because the amplifying element of an amplifier is not a complete linear element but a nonlinear element. Similarly, when two signals different in a frequency are input to the input terminal IN of the amplifier, the fundamental signals of the two signals and a signal with a frequency of the sum or difference of the frequencies of the fundamental signals, that is, a secondary intermodulation component (hereinafter called IM2) and a signal with a frequency of difference between a twice as many frequency as the frequency of either fundamental signal and the frequency of the other fundamental signal, that is, a tertiary intermodulation component (hereinafter called IM3) is output. IM2 is generated because of the secondary distortion of an amplifying element and IM3 is generated because of the tertiary distortion. In this specification, an output signal is composed of a fundamental signal, IM2 and IM3 for convenience. Fig. 11 shows input-output behavioral characteristics showing the output levels of a fundamental signal, IM2 and IM3 to the level of an input signal in case two signals different in a frequency are input to the amplifier shown in Fig. 7.

The x-axis of Fig. 11 shows the level of an input signal input to the input terminal IN of the amplifier, the y-axis shows the level of an output signal from the output terminal OUT of the amplifier and the above levels are measured values in a state terminated at 75 Ω. Curves D, E and F in Fig. 11 respectively show the fundamental signal, IM2 and IM3 at the output terminal OUT of the amplifier and the fundamental signal of these changes according to the relationship of 1 to 1 with the level of an input signal as shown in the curve D. That is, for example, if the level of the input signal is raised by 10 dB, the level of an output signal also rises by 10 dB. In the meantime, IM2 (the curve E shown in Fig. 11) and IM3 (the curve F shown in Fig. 11) respectively change according to the relationship of 1 to 2 and 1 to 3 with the level of an input signal. That is, for example, if the level of the input signal is raised by 10 dB, the levels of output signals respectively rise by 20 dB and 30 dB. Therefore, the tilt of the curve E showing the input-output behavioral characteristics of IM2 is sharper than that of the curve D showing the input-output behavioral characteristics of the fundamental signal and similarly, the tilt of the curve F showing the input-output behavioral characteristics of IM3 is sharper than that of the curve E showing the input-output behavioral characteristics of IM2. The respective dotted parts of the curves D, E and F show that values in the parts are beyond the range of observation and are theoretical estimated parts.

Therefore, when the level of an input signal is raised, the curve D showing the input-output behavioral characteristics of the fundamental signal and the curve E showing the input-output behavioral characteristics of IM2 cross at a point X1 and similarly, the curve D showing the input-output behavioral characteristics of the fundamental signal and the curve F showing the input-output behavioral characteristics of IM3 cross at a point X2. These intersections are called an intercepted point, are a standard for judging whether the characteristic of distortion in an amplifier is good or bad and the higher the level of an input signal at an intercepted point is, the more satisfactory amplifier for distortion the amplifier is. In Fig. 11, the level of an input signal at the intercepted point of the fundamental signal and IM2 is approximately 90 dB millivolt (mV) and the level of the input signal at the intercepted point of the fundamental signal and IM3 is approximately 67.5 dBmV.

In the input-output behavioral characteristic shown in Fig. 11, at the practical level of 30 dBmV for example as to the level of an input signal, the level of IM2 to that of the fundamental signal and the level of IM3 to that of the fundamental signal (desired-to-undesired signal ratio (DU)) are respectively -60 dB and -75 dB and these DUs are never satisfactory values.

Therefore, if such an amplifier is used for a wideband amplifier and further, a large number of channels of signals different in a frequency are simultaneously input and amplified as in a receiver in CATV system, input signals are mixed by an amplifying element and a large number of beats to be jamming are generated.

If in future, broadcasting channels are increased and further, a system is switched to digital broadcasting, this is particularly a problem.

The object of the present invention is to realize a low-distortion amplifier suitable for a wideband amplifier in which the level of a generated jamming signal can be controlled so that it is low even if multiple signals different in a frequency are amplified.

To solve the above problem, an amplifier according to the present invention comprises an amplifying element provided with an input terminal and an output terminal and provided with nonlinearity in which as input voltage is increased, the differential coefficient of output current to input voltage increases and a two-terminal element provided with two terminals in which as voltage applied between the two terminals is increased, the differential coefficient of current flowing between the two terminals to the voltage applied between said two terminals decreases and is characterized in that one end of the two-terminal element is connected to the input terminal of the amplifying element, an input signal is supplied to the other end of the two-terminal element and output current flowing to the output terminal of the amplifying element is let to flow through the two-terminal element via the input terminal.

The amplifier according to the present invention may be characterized in that the above amplifying element is single-gate FET the gate of which is grounded and the source of the above FET is the above input terminal.

The amplifier according to the present invention may be characterized in that the above two-terminal element is second single-gate FET and the drain and the source of the second FET are the above two terminals and the gate is connected to the source.

The amplifier according to the present invention may be characterized in that bias voltage is applied between the source and the gate of the above second single-gate FET.

The amplifier according to the present invention may be characterized in that dual-gate FET provided with a first gate, a second gate, a source and a drain is used, the source and the first gate are connected D.C. (direct current), an input signal is input to the source and an output signal is output from the drain.

The amplifier according to the present invention may be characterized in that bias voltage which lets electric potential at the first gate be lower than the electric potential of the source is applied between the first gate and the source.

Embodiments of the invention will now be described, by way of example only, with reference to the accompanying drawings, in which:

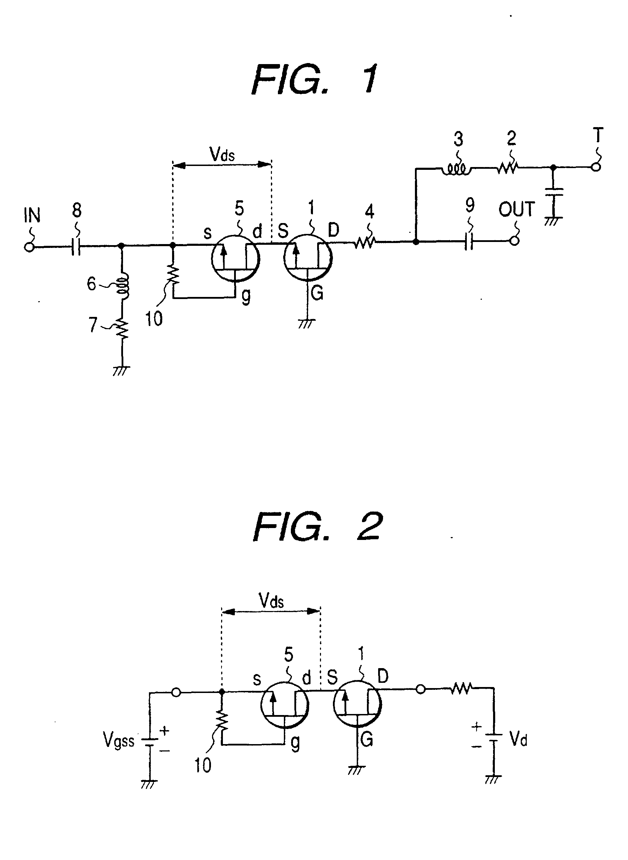

Fig. 1 is a circuit diagram showing an amplifier equivalent to a first embodiment of the present invention;
Fig. 2 shows a circuit for measuring the voltage/current characteristics of the amplifier equivalent to the first embodiment of the present invention;

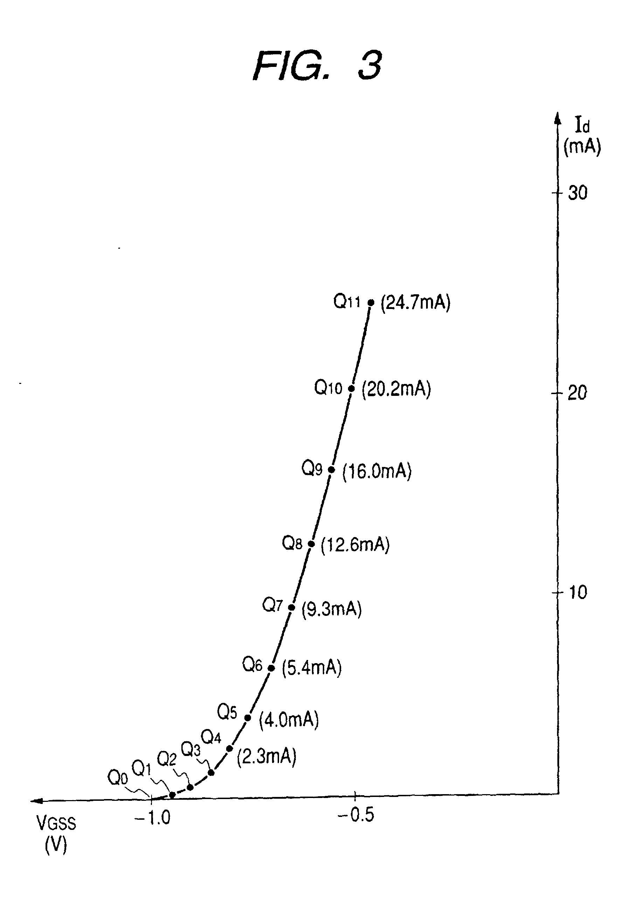

Fig. 3 shows the voltage/current characteristics of the amplifier equivalent to the first embodiment of the present invention;

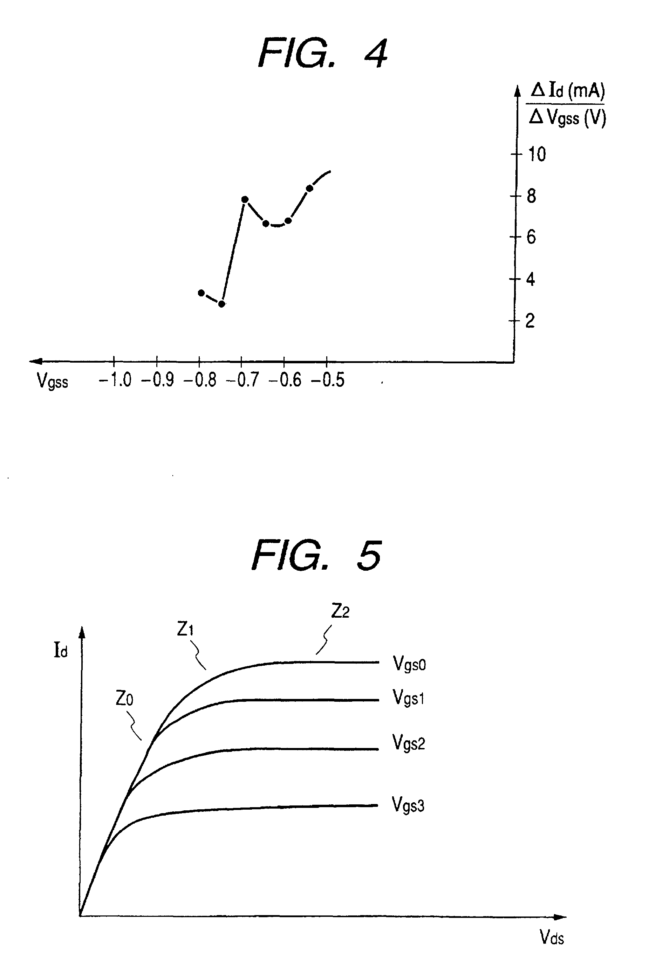

Fig. 4 shows a differential coefficient in the voltage/current characteristics of the amplifier equivalent to the first embodiment of the present invention;
Fig. 5 shows the voltage/current characteristics of a two-terminal element in the amplifier equivalent to the first embodiment of the present invention;

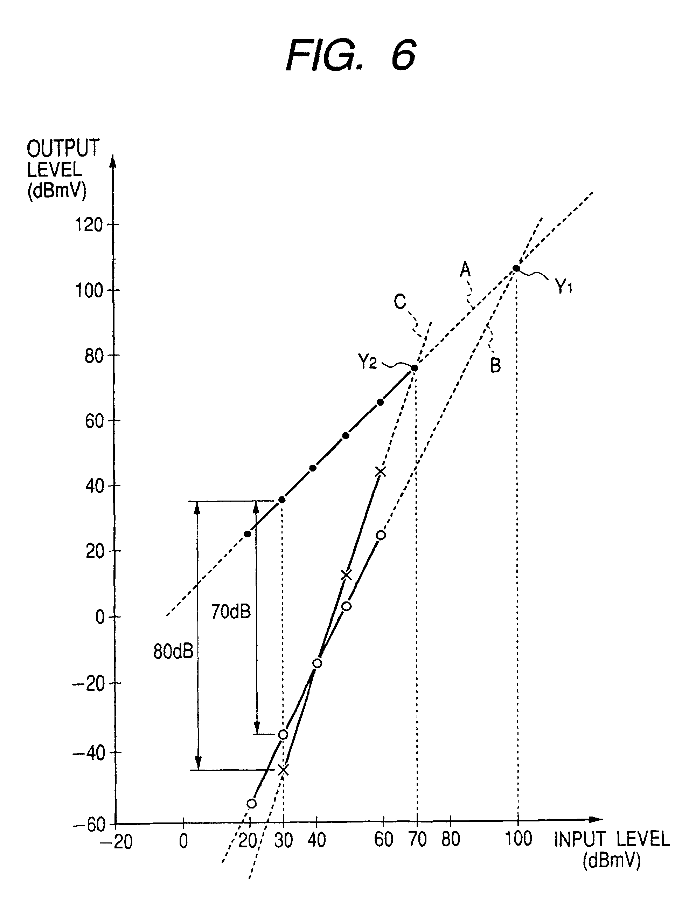

Fig. 6 shows the input-output behavioral characteristics of the amplifier equivalent to the first embodiment of the present invention;
Fig. 7 is a circuit diagram showing a conventional type amplifier;
Fig. 8 shows a circuit for measuring the voltage/current characteristics of the conventional type amplifier;
Fig. 9 shows the voltage/current characteristics of the conventional type amplifier;
Fig. 10 shows a differential coefficient in the voltage/current characteristics of the conventional type amplifier;
Fig. 11 shows the input-output behavioral characteristics of the conventional type amplifier;

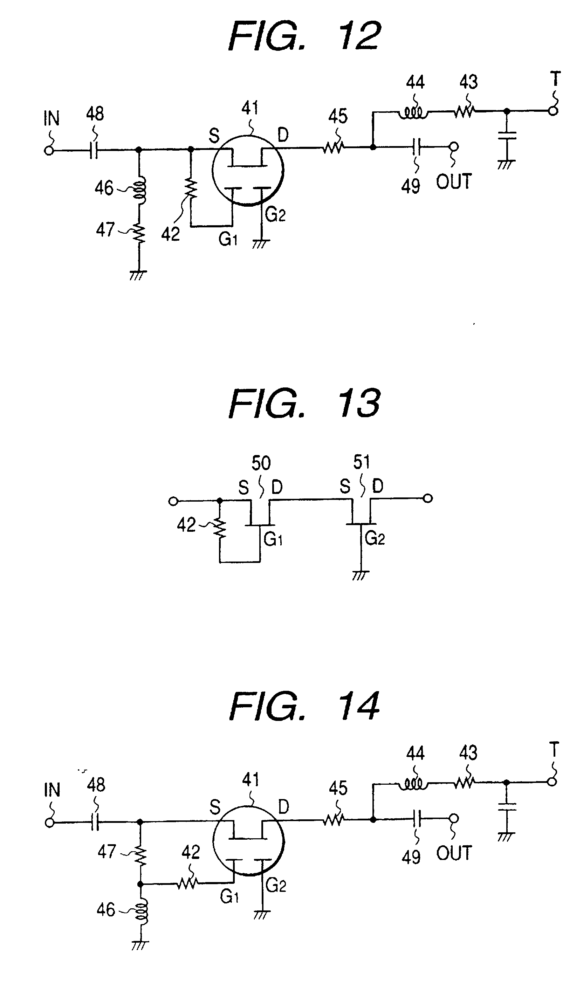

Fig. 12 is a circuit diagram showing an amplifier equivalent to a second embodiment of the present invention;
Fig. 13 is an explanatory drawing showing dual-gate FET used for the amplifier equivalent to the second embodiment of the present invention; and
Fig. 14 is a circuit diagram showing the amplifier equivalent to the second embodiment of the present invention.

Referring to Figs. 1 to 6, a first embodiment of the present invention will be described below. First, Fig. 1 shows an amplifier according to the present invention, a single-gate N-channel FET is used for FET 1 which is an amplifying element and the gate G is grounded. Power supply voltage is supplied from a power terminal T to the drain D which is an output terminal via a resistor 2 of approximately 10 Ω, a choke inductor 3 of approximately 0.1 µH and a resistor 4 of approximately 33 Ω respectively mutually connected in series.

A drain d which is one end of second FET 5 is connected to a source S which is the input terminal of FET 1 and a source s which is the other end of the second FET 5 is grounded via a choke inductor 6 of approximately 6.8 nH and a resistor 7 of approximately 75 Ω. The second FET 5 is used for a two-terminal element both ends of which are the drain d and the source s. Therefore, owing to the above constitution, the drain current Id of FET 1 which is an amplifying element flows between the drain d and the source s of the second FET 5 which is a two-terminal element via the source S of FET 1. The amplifier is constituted so that an input signal is input from the input terminal IN of the amplifier to the source s of the second FET 5 via a direct current blocking capacitor 8 of 6.8 nF and an output signal from the drain D of FET 1 is extracted from the output terminal OUT of the amplifier via the resistor 4 and a direct current blocking capacitor 9. The gate g of the second FET 5 is connected to the source s of the second FET 5 in direct current via a resistor 10. Therefore, the gate g of the second FET 5 does not apply bias voltage to the source s and the source s is kept at the same electric potential.

In the amplifier, the second FET 5 is used for a two-terminal element, the drain current Id of FET 1 flows between the drain d and the source s of the second FET 5 as it is and flows to the choke inductor 6 and the resistor 7. As a result, voltage Vds between the drain d and the source s of the second FET 5 and a voltage drop caused in the resistor 7 apply bias voltage which biases the negative voltage of approximately -0.7 V to the gate G to the source S of FET 1. The resistor 4 connected to the drain D of FET 1 is provided to enhance the stability of the amplifier and prevent oscillation. The choke inductors 3 and 6 are provided to prevent a high frequency.

The second FET 5 which is a two-terminal element connected to the source S of FET 1 which is an amplifying element is provided to reduce the distortion of FET 1 and referring to Figs. 2 to 5, the voltage/current characteristics of the amplifier shown in Fig. 1 including the action of the second FET 5 will be described below. First, Fig. 2 shows a circuit for measuring the voltage/current characteristics of the amplifier shown in Fig. 1, the gate G of FET 1 is grounded and drain voltage Vd is applied to the drain D. The drain d of the second FET 5 as a two-terminal element is connected to the source S of FET 1 and gate bias voltage Vgss for applying negative voltage to the gate G via the source S of FET 1 is applied to the source s of the second FET 5. The gate g of the second FET 5 is connected to the source s via the resistor 10, and the source s and the gate g are kept at the same electric potential. Fig. 3 shows voltage/current characteristics showing a result of measuring the change of the drain current of FET 1 by changing gate bias voltage Vgss.

The x-axis of Fig. 3 shows gate bias voltage Vgss (as to the actual voltage of the gate G to the source S of FET 1, voltage between the drain d and the source s of the second FET 5 is added to gate bias voltage Vgss) and the y-axis shows drain current Id flowing to the drain D of FET 1. As described above, the drain current Id flows between the drain d and the source s of the second FET 5. A curve showing voltage/current characteristics shows that when gate bias voltage Vgss is changed from a minus toward zero volt, drain current Id increases, however, the tilt is gentler than the tilt of the voltage/current characteristics in the conventional type amplifier shown in Fig. 9 and in addition, the tilt is straighter.

That is, points Q0 to Q11 on the curve showing the voltage/current characteristics shown in Fig. 3 show measured drain current Id under gate bias voltage Vgss at an interval of 0.05 V and a tilt between adjacent measurement points, that is, a differential coefficient (ΔIdD/ΔVgss, ΔId shows difference in drain current between adjacent measurement points and ΔVgss is equivalent to 0.05 V) hardly changes while gate bias voltage Vgss is between -0.7 V and -0.5 V as shown in Fig. 4. This is greatly different from the curve showing the differential coefficient of the conventional type shown in Fig. 10. This shows the voltage/current characteristics shown in Fig. 3 in the measuring circuit, that is, the amplifier according to the present invention shown in Fig. 1 are straighter than those of the conventional type amplifier. The amplifier is set so that it is used in a range between -0.7 V and -0.5 V of gate bias voltage Vgss.

The above tilt of the voltage/current characteristics approximates a so-called differential coefficient and a tilt when the interval (0.05 V) of the measurement of gate bias voltage Vgss in the above measurement is reduced infinitely is an accurate differential coefficient. However, in this specification, a tilt at the above interval of 0.05 V is regarded as a differential coefficient for convenience.

The reason why the voltage/current characteristics shown in Fig. 3 are linear is that current Id (equal to the drain current Id of FET 1) which flows between the drain d and the source s to voltage Vds between the drain d and the source s of the second FET 5 as a two-terminal element connected to the source S of FET 1 which is an amplifying element is provided with a characteristic in which the tilt (differential coefficient) is monotonically decreased as voltage Vds is increased, and will be described in detail below. First, Fig. 5 shows voltage/current characteristics showing relationship between voltage Vds applied between the drain d and the source s of the second FET 5 and drain current Id which flows between the drain d and the source s at that time and the curve Vgs0 of the voltage/current characteristics shows a case that gate bias voltage between the source s and the gate g is zero volt at the same electric potential. Curves Vgs1, Vgs2 and Vgs3 respectively show a case that gate bias voltage between the source S and the gate G is increased in a negative direction.

For example, in the curve Vgs0, a range of the change of the tilt (differential coefficient) of drain current Id is increased as a part Z0 in which drain current is approximately linearly increased, a part Z1 in which the tilt (differential coefficient) is monotonically decreased and a part Z2 in which the tilt (differential coefficient) is approximately zero and fixed respectively as voltage Vds between the drain d and the source s is increased. However, the second FET 5 is mainly used in an area of the part Z1 in which the tilt (differential coefficient) of drain current Id is monotonically decreased. As a result, voltage Vds between the drain d and the source s of the second FET 5 is superposed upon gate bias voltage Vgss and gate bias voltage Vgs is applied between the source S and the gate G of FET 1 which is an amplifying element. However, voltage Vds between the drain d and the source s of the second FET which accounts for gate bias voltage Vgs between the source S and the gate G of FET 1 as the drain current Id of FET 1 is increased, whereby the absolute value of gate bias voltage Vgs between the source S and the gate G of FET 1 is reduced and the tilt of the curve of the voltage/current characteristics becomes gentle as shown in Fig. 3 and linear.

In the amplifier shown in Fig. 1, gate bias voltage Vgs between the source s and the gate g of the second FET 5 is set to zero volt (the same electric potential) and it is described above using the curve Vgs0 shown in Fig. 5. However, it need hardly be said that suitable gate bias voltage Vgs may be applied between the source s and the gate g. In this case, the range of the change of the tilt (differential coefficient) is similarly large. Hereby, the voltage/current characteristics of the amplifier can be straighter.

In the amplifier provided with such voltage/current characteristics and the constitution shown in Fig. 1, when two signals different in a frequency are input to the input terminal IN of the amplifier, the fundamental signals of these two signals, a signal with a frequency of the sum or the difference of the frequencies of the fundamental signals, that is, a secondary intermodulation component (hereinafter called IM2) and a signal with a frequency of difference between a twice as many frequency as the frequency of either fundamental signal and the frequency of the other fundamental signal, that is, a tertiary intermodulation component (hereinafter called IM3) are output from the output terminal OUT of the amplifier. IM2 is caused by the secondary distortion of the amplifying element and IM3 is caused by the tertiary distortion. The fundamental signals, IM2 and IM3 are respectively increased as the levels of the input signals rise, however, as the voltage/current characteristics are straighter, the levels of IM2 and IM3 can be controlled so that they are lower, compared with those in the conventional type. Fig. 6 shows input-output behavioral characteristics showing the levels of the output signals of the fundamental signals, IM2 and IM3 to the levels of the input signals in the amplifier shown in Fig. 1.

The x-axis of Fig. 6 shows the levels of input signals input to the input terminal IN of the amplifier, the y-axis shows the levels of output signals at the output terminal OUT of the amplifier and both levels are measured in a state terminated at 75 Ω. Curves A, B and C in Fig. 6 respectively show a fundamental signal, IM2 and IM3 at the output terminal OUT of the amplifier and the fundamental signal of these changes according to the relationship of 1 to 1 with the level of an input signal as shown by the curve A. That is, for example, if the level of an input signal is raised by 10 dB, the level of the output signal also rises by 10 dB. In the meantime, IM2 shown by the curve B in Fig. 6 and IM3 shown by the curve C in Fig. 6 respectively change according to the relationship of 1 to 2 and 1 to 3 with the level of an input signal. That is, for example, if the level of an input signal is raised by 10 dB, the levels of the output signals respectively rise by 20 dB and 30 dB. Therefore, the tilt of the curve B showing the output characteristic of IM2 is sharper than the tilt of the curve A showing the input-output behavioral characteristics of the fundamental signal. Similarly, the tilt of the curve C showing the output characteristic of IM3 is sharper than the tilt of the curve B showing the output characteristic of IM2. Since each dotted part in the curves A, B and C shows values beyond the range of observation, it is a theoretical estimated part.

Therefore, as the level of an input signal rises, the levels of intermodulation components IM2 and IM3 output from the output terminal OUT of the amplifier rise. However, for example, an intercepted point Y1 at which the curve A showing the input-output behavioral characteristics of the fundamental signal and the curve B showing the output characteristic of IM2 cross and an intercepted point Y2 at which the curve A showing the input-output behavioral characteristics of the fundamental signal and the curve C showing the output characteristic of IM3 cross are shifted toward a larger input signal level than those in the conventional type amplifier, the values of input levels at the above intercepted points are respectively 100 dBmV and 70 dBmV and it is shown that particularly, the level of IM2 is inhibited. Therefore, at a practical level at which the level of an input signal is 30 dBmV for example, the level of IM2 to that of the fundamental signal and the level of IM3 to that of the fundamental signal (desired-to-undesired signal ratio (DU)) are respectively -70 dB and -80 dB and are respectively improved by 10 dB and 5 dB, compared with the above levels in the conventional type.

As described above, as in the amplifier according to the present invention, the distortion of the amplifier is reduced by using another element for removing the nonlinear characteristic of the amplifying element 1 of the amplifier such as the two-terminal element 5, an amplifier provided with a distortion characteristic excellent as a wideband amplifier for simultaneously amplifying multiple signals different in a frequency can be realized.

As for the amplifying element of the amplifier according to the present invention, single-gate FET 1 is used for explanation, however, the present invention is not limited to this, for example, dual-gate FET may be also used and a bipolar transistor may be also used. Further, a two-terminal element is not limited to a field effect transistor such as the second FET 5 and for example, a bipolar transistor may be also used.

If the second FET 5 is used for a two-terminal element, bias voltage between the source s and the gate g is also not required to be fixed to zero volt and the linearity of the whole amplifier can be more enhanced by applying suitable bias voltage.

Next, referring to Figs. 12 to 14, a second embodiment of the present invention will be described. As shown in Fig. 12, dual-gate FET (hereinafter called only FET) 41 provided with a first gate G1, a second gate G2, a drain D and a source S is used for an amplifying element, the first gate G1 is connected to the source via a resistor 42 in direct current, and the first gate G1 and the source S are kept at the same electric potential. The second gate G2 is grounded. Further, power supply voltage is supplied from a power terminal T to the drain D which is the output terminal of FET 41 via a resistor 43 of approximately 10 Ω, a choke inductor 44 of approximately 0.1 µH and a resistor 45 of approximately 33 Ω respectively mutually connected in series.

The source S which is the input terminal of FET 41 is grounded via a choke inductor 46 of approximately 6.8 nH and a resistor 47 of approximately 75 Ω. Therefore, according to the above constitution, the drain current Id of FET 41 which is an amplifying element flows to the ground via the source S of FET 41. An input signal is input from the input terminal IN of the amplifier to the source S of FET 41 via a direct current blocking capacitor 48 of 6.8 nF and an output signal from the drain D of FET 41 is extracted from the output terminal OUT of the amplifier via the resistor 45 and a direct current blocking capacitor 49.

In the amplifier equivalent to the second embodiment, one dual-gate FET 41 is used for an amplifying element, however, dual-gate FET 41 has the same configuration as in a case that two single-gate FETs 50 and 51 are cascaded as shown in Fig. 13 as is generally known and therefore, the operation of the amplifier shown in Fig. 12 is the same as that of the amplifier equivalent to the first embodiment shown in Fig. 1. In this case, the first gate G1 and the source S of FET 41 function as the two-terminal element 5 shown in Fig. 1 and the second gate G2 and the drain D of FET 41 function as the amplifying element 1 shown in Fig. 1. As described above, the amplifier equivalent to the second embodiment of the present invention can be configured as an amplifier in which intermodulation distortion is small by using one dual-gate FET 41.

Fig. 14 shows an amplifier wherein positions in which the choke inductor 46 and the resistor 47 respectively connected between the source S of FET 41 in the amplifier shown in Fig. 12 and the ground are inserted are exchanged, the choke inductor 46 is inserted on the side of the ground and the first gate G1 is connected to a connection between the choke inductor 46 and the resistor 47 via the resistor 42. As a result, the first gate G1 is changed to the same electric potential as the ground, the source S is changed to high electric potential to the ground because of a voltage drop by the resistor 47 caused by current from the source S and bias voltage can be applied to the first gate G1. Therefore, the linearity of the amplifier can be enhanced by optimizing the bias voltage.

As described above, the amplifier according to the present invention comprises the amplifying element provided with the input terminal and the output terminal and provided with nonlinearity in which the differential coefficient of output current increases as input voltage is increased and the two-terminal element provided with two terminals in which the differential coefficient of current flowing between the two terminals decreases as voltage applied between the two terminals is increased, and characterized in that as one end of the two-terminal element is connected to the input terminal of the amplifying element, an input signal is supplied to the other end of the two-terminal element and output current flowing to the output terminal of the amplifying element flows to the two-terminal element via the input terminal, the nonlinear characteristic of the amplifying element of the amplifier can be canceled by the two-terminal element and the distortion of the amplifier can be reduced. As a result, the amplifier provided with a distortion characteristic excellent as a wideband amplifier for simultaneously amplifying multiple signals different in a frequency can be realized.

As in the amplifier according to the present invention, the amplifying element is constituted by single-gate FET the gate of which is grounded and the source of FET functions as the above input terminal, the drain current of FET can flow to the two-terminal element as it is only by connecting the two-terminal element to the source of FET and the configuration of the amplifier can be simplified.

As in the amplifier according to the present invention, the two-terminal element functions as second single-gate FET and the drain and the source of the second FET function as the two terminals, the range of the change of a tilt in the voltage/current characteristics of the second FET is widened and voltage and drain current between the drain and the source of the second FET for canceling the nonlinear characteristic of the amplifying element can be suitably set.

As in the amplifier according to the present invention, a bias voltage is applied between the source and the gate of the second single-gate FET, voltage and current between the drain and the source of the second FET for canceling the nonlinear characteristic of the amplifying element can be more easily set.

As in the amplifier according to the present invention, dual-gate FET provided with a first gate, a second gate, a source and a drain is used, the source and the first gate are connected in direct current, an input signal is input to the source and an output signal is extracted from the drain, the first gate and the source of the dual-gate FET function as a two- terminal element and the second gate and the drain of the FET function as an amplifying element. Therefore, the amplifier in which intermodulation distortion is small can be configured by using one dual-gate FET.

As in the amplifier according to the present invention, bias voltage which lowers electric potential at the first gate so that it is lower than the electric potential of the source is applied between the first gate and the source, the linearity of the amplifier can be enhanced by optimizing the bias voltage.

## Claims

1. An amplifier, comprising:
an amplifying element provided with an input terminal and an output terminal and provided with a nonlinear characteristic in which as input voltage is increased, the differential coefficient of output current to input voltage increases; and
a two-terminal element provided with two terminals in which as voltage applied between said two terminals is increased, the differential coefficient of current flowing between said two terminals to the voltage applied between said two terminals decreases, wherein:
one end of said two-terminal element is connected to said input terminal of said amplifying element;
an input signal is supplied to the other end of said two-terminal element; and
output current flowing to said output terminal of said amplifying element flows through said two-terminal element via said input terminal.

2. An amplifier according to Claim 1, wherein:
said amplifying element is a single-gate FET, the gate of which is grounded; and
the source of said FET is equivalent to said input terminal.

3. An amplifier according to Claim 1 or 2, wherein:
said two-terminal element is second single-gate FET; and
the drain and the source of said second FET are equivalent to said two terminals and the gate is connected to the source.

4. An amplifier according to Claim 3, wherein:
bias voltage is applied between the source and the gate of said second single-gate FET.

5. An amplifier, wherein:
a dual-gate FET provided with a first gate, a second gate, a source and a drain is used;
said source and said first gate are direct current connected;
an input signal is input to said source; and
an output signal is extracted from said drain.

6. An amplifier according to Claim 5, wherein:
a bias voltage which lowers electric potential at said first gate so that it is lower than the electric potential of said source is applied between said first gate and said source.

## Patentansprüche

1. Verstärker bestehend aus:
einem Verstärkungselement, versehen mit einem Eingangsanschluss und einem Ausgangsanschluss und eine nichtlineare Charakteristik aufweisend , bei der mit steigender Eingangsspannung der Differentialkoeffizient von Ausgangsstrom zu Eingangsspannung zunimmt;
einem Zweipol- Element, versehen mit zwei Anschlüssen, bei dem mit steigender Spannung an den besagten beiden Anschlüssen der Differentialkoeffizient des Stroms, der zwischen den beiden Anschlüssen fließt, zu der Spannung, die an den besagten beiden Anschlüssen angelegt ist, abnimmt, wobei:
ein Anschluss des besagten Zweipol- Elements an den besagten Eingangsanschluß des besagten Verstärkungselements angeschlossen ist;
ein Eingangssignal an den anderen Anschluss des besagten Zweipol- Elements angelegt wird; und der Ausgangsstrom, der zu dem Ausgangsanschluss des besagten Verstärkungselements fließt, durch das besagte Zweipol- Element über den besagten Eingangsanschluss fließt.

2. Verstärker nach Anspruch 1, wobei:
das besagte Verstärkungselement ein Single- Gate FET ist, dessen Gate an Masse liegt;
und wobei der Sourceanschluss dem besagten Eingangsanschluss entspricht.

3. Verstärker nach Anspruch 1 oder 2, wobei:
das besagte Zweipol- Element ein zweiter Single- Gate FET ist;
und wobei Drain- und Source- Anschlüsse des besagten Zweiten FET den besagten zwei Anschlüssen entsprechen und das Gate mit der Source verbunden ist.

4. Verstärker nach Anspruch 3, wobei:
zwischen Sourceanschluss und Gateanschluss des besagten zweiten Single- Gate FET eine Vorspannung angelegt wird.

5. Verstärker, wobei:
ein Dual- Gate FET mit einem ersten Gateanschluss, einem zweiten Gateanschluss. einem Sourceanschluss und einem Drainanschluss verwendet wird;
besagter Sourceanschluss und der erste Gateanschluss gleichstrommäßig verbunden sind;
ein Eingangssignal an besagten Sourceanschluss angelegt wird; und
ein Ausgangssignal von besagtem Drainanschluss abgenommen wird.

6. Verstärker nach Anspruch 5, wobei:
eine Vorspannung, die das elektrische Potential an besagtem ersten Gateanschluss erniedrigt, so dass es niedriger ist als das elektrische Potential an besagtem Sourceanschluss zwischen dem besagtem ersten Gateanschluss und dem besagtem Sourceanschluss angelegt wird.

## Revendications

1. Amplificateur, comprenant :
un élément amplificateur muni d'une borne d'entrée et d'une borne de sortie, et possédant une caractéristique non linéaire selon laquelle, quand la tension d'entrée augmente, le coefficient différentiel du courant de sortie sur la tension d'entrée augmente ; et
un élément à deux bornes muni de deux bornes, pour lequel, quand la tension appliquée entre lesdites deux bornes augmente, le coefficient différentiel du courant circulant entre lesdites deux bornes sur la tension appliquée entre lesdites deux bornes décroît, dans lequel :
une extrémité dudit élément à deux bornes est connectée à ladite borne d'entrée dudit élément amplificateur ;
un signal d'entrée est fourni à l'autre extrémité dudit élément à deux bornes ; et
un courant de sortie circulant vers ladite borne de sortie dudit élément amplificateur circule à travers ledit élément à deux bornes, via ladite borne d'entrée.

2. Amplificateur selon la revendication 1, dans lequel :
ledit élément amplificateur est un transistor à effet de champ (TEC) à une seule grille, dont la grille est mise à la terre ; et
la source dudit TEC est équivalente à ladite borne d'entrée.

3. Amplificateur selon la revendication 1 ou 2, dans lequel :
ledit élément à deux bornes est un deuxième TEC à une seule grille ; et
le drain et la source dudit deuxième TEC sont équivalents aux dites deux bornes, et la grille est connectée à la source.

4. Amplificateur selon la revendication 3, dans lequel :
une tension de polarisation est appliquée entre la source et la grille dudit deuxième TEC à une seule grille.

5. Amplificateur, dans lequel :
un TEC à double grille, muni d'une première grille et d'une deuxième grille, d'une source et d'un drain, est utilisé ;
ladite source et ladite première grille sont branchées en courant continu ;
un signal d'entrée est entré dans ladite source ; et
un signal de sortie est sorti dudit drain.

6. Amplificateur selon la revendication 5, dans lequel :
une tension de polarisation, qui abaisse le potentiel électrique au niveau de ladite première grille de telle sorte qu'il soit inférieur au potentiel électrique de ladite source, est appliquée entre ladite première grille et ladite source.
